# EUROPEAN PATENT SPECIFICATION

(11) **EP 0 922 905 B1**
(45) Date of publication and mention of the grant of the patent: **30.03.2005**
(21) Application number: 98310060.3
(22) Date of filing: 08.12.1998
(51) Int. Cl.: F22B 1/00, C01B 5/00, H01L 21/316

(54) **Improvements in or relating to a method for the generation of water vapour**
Verfahren zur Erzeugung von Wasserdampf
Méthode pour produire de la vapeur d'eau

(30) Priority: 10.12.1997 JP 34028397
(43) Date of publication of application: 16.06.1999
(73) Proprietor: Fujikin Inc., Nishi-ku, Osaka (JP); Hitachi, Ltd., Chiyoda-ku, Tokyo 101 (JP)
(72) Inventor: Minami, Yukio, Osaka (JP); Kawada, Koji, Osaka (JP); Tanabe, Yoshikazu, Oume-shi, Tokyo (JP); Ikeda, Nobukazu, Osaka (JP); Morimoto, Akihiro, Osaka (JP)
(74) Representative: Faulkner, Thomas John

(56) References cited:
- EP-A- 0 209 065
- CA-A- 2 244 688

## Description

The present invention relates to a method of generating water vapour for use in a semiconductor manufacturing industry comprising the features of the preamble claim 1. Such a method is known from WO-A-97/28085.

In the manufacture of semiconductor elements, the conventional 'dry O₂ oxidation' technique for coating silicon oxide film by thermal oxidation has now been largely replaced by the 'moisture oxidation' technique (also known as the 'wet O₂ oxidation' method). Silicon oxide films formed by the moisture oxidation technique are generally superior to those obtained by the dry O₂ oxidation technique in properties such as insulation strength and masking effect.

Oxide film coating by the aforesaid moisture oxidation technique uses a gas mixture comprising oxygen and water vapour, with a moisture content typically in the range 20 to 30 percent.

Water vapour is mixed with the oxygen at a rate typically in range 200 to 2000 cm³/min. Thus a relatively large quantity of water vapour is fed from a reactor for the generation of moisture to the semiconductor manufacturing facility.

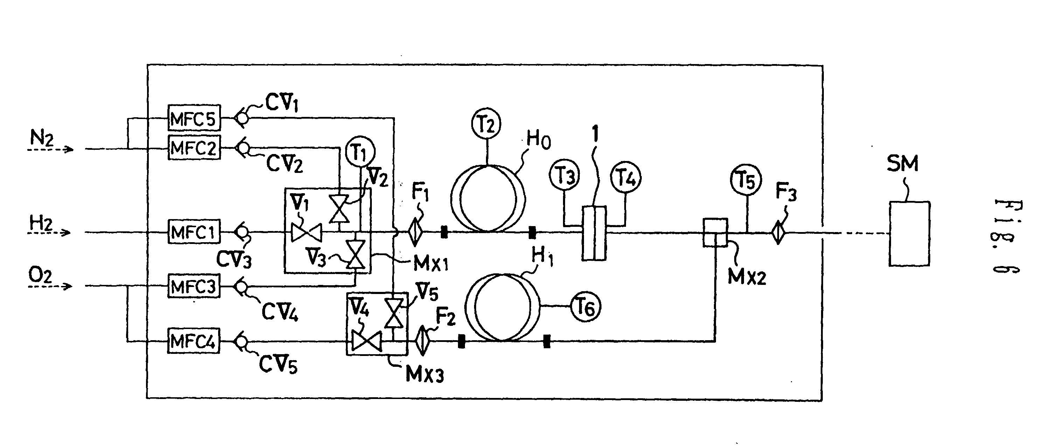

Fig. 6 shows an apparatus disclosed in W097/28085 for the generation of moisture that forms part of the state of the art for use in the moisture oxidation technique. In Fig. 6, MFC₁ to MFC₅ are mass controllers; V₁ to V₅ are valves; T₁ to T₆ are thermocouples for measuring temperature; CV₁ to CV₅ are check valves; F₁ to F₃ are filters; H_{θ} and H₁ are gas preheater coils; MX₁ is an 0₂-H₂ mixer; MX₂ is an O₂-moisture mixer; 1 is a reactor for generation of moisture; and SM is processing equipment such as a semiconductor manufacturing facility.

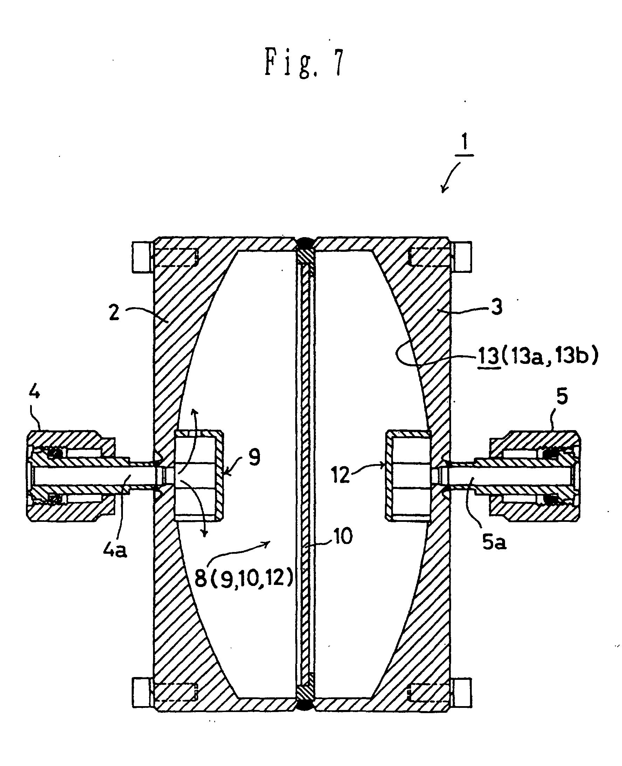

Said reactor 1 is shown in more detail in figure 7, from which it can be seen that the reactor comprises reactor structural components 2 and 3 provided respectively with a gas supply joint 4 and a moisture gas take-out joint 5. Said gas supply joint defines a gas feed passage 4a, and the reactor 1 accommodates a reflector 9 that opposes said gas feed passage 4a. A further reflector 12 is provided within the reactor, which further reflector 12 opposes a gas outlet passage 5a that is defined by said take-out joint 5. A filter 10 is provided generally in the middle of the reactor 1, and the inside wall of the reactor structural component 3 is provided with a platinum coated catalyst layer 13.

Said platinum coated catalyst layer 13 has a double layer construction, comprising a barrier coat 13a with a platinum coat 13b formed thereupon. Said barrier coat 13a is formed of a nitride such as TiN, on which the platinum coat 13b is fixed by vapour deposition or ion coating.

Hydrogen and oxygen are fed into the reactor 1 through said gas feed passage 4a and are diffused by gas diffusion means 8 comprising the reflector 9, the filter 10 and the further reflector 12. Said gas mixture contacts said platinum coated catalyst layer 13, which causes or allows the generation of hydrogen and oxygen free radicals. Said hydrogen and oxygen free radicals react very quickly with each other at temperatures lower than ignition point to produce water molecules without undergoing combustion.

The flow rates of the hydrogen and oxygen into the reactor 1 are set respectively to, for example, about 1000 and 600 cm³/min, such that the mixture is typically about 20% wt oxygen rich. The gas supply pressure of oxygen and hydrogen is set in the range 1.0 to 3.0kg/cm² to produce about 1000cm³/min of moisture. The reactor 1 typically has an outer diameter of about 114mm, a wall thickness of about 31mm, and an internal volume of about 86cm³.

Said platinum coated catalyst layer may have a surface area of about 99cm². Though very small in size as shown, said reactor can produce in excess of 1000cm³/min of water vapour.

Downstream of the outlet of the reactor 1 is provided an O₂-moisture mixer Mx2, where the moisture can be mixed with oxygen in any desired ratio and thus diluted.

Fig. 6 illustrates an operation in which a 20 percent oxygen-rich gas mixture is fed into the reactor 1. Said reactor 1 could alternatively be operated with a hydrogen-rich gas mixture. In such an arrangement, an H₂-moisture mixer Mx1 would be provided instead of the O₂-moisture mixer Mx2.

Said preheater coils H₀ and H₁ are arranged respectively for heating the gas mixture and oxygen to a temperature not higher than about 200°C. Said reactor 1 may also be provided with a heater and, optionally, a cooler such that if the heat generated by the reaction increases the temperature in the reactor to over say 500°C, the cooler is actuated to reduce the temperature below 500°C. In addition, the gas mixture in the mixer Mx2 is maintained at a temperature of about 120°C to prevent water from condensing on the pipe wall. A heater is provided as necessary.

Prior to starting up the reactor 1 for the generation of moisture, the mass flow controllers MFC1 to MFC5 and temperature controllers are set to provide predetermined gas mass flow rates, the valves V2 and V5 are opened, and the valves V1, V3 and V4 are closed to purge the system with nitrogen.

The valves V2 and V5 are then closed. Contemporaneously, or after a short time, the valves V3 and V4 are opened to feed oxygen into the system. At the same time, or after a further short time, the valve V1 is opened to feed hydrogen into the system.

On contacting the platinum coated catalyst layer, the oxygen and hydrogen molecules are radicalized, and the resulting free radicals react with each other to produce about 1000 cm³/min of moisture gas, which is supplied to the semiconductor manufacturing facility, SM.

Said mass flow controllers MFC1 to MFC5 are constituted such that the gas flow rates reach their pre-set flow rates as soon as possible. That is, the oxygen and hydrogen flow rates reach their set levels within about one second.

The moisture generator illustrated in Fig. 6 is capable of generating in excess of about 1000cm³/min high-purity water. The amount of moisture to be generated and supplied can be controlled relatively easily and with high precision by regulating the supply of oxygen and hydrogen.

However, that moisture generator also has a number of disadvantages. In particular, the reactor does not allow the flow rate of moisture to be controlled when said moisture is generated in very small quantities.

Recently the 'low moisture oxidation' method has been put to wide practical application in silicon oxide film coating. Such low moisture oxidation requires the use of a gas mixture comprising oxygen and water vapour, with a moisture content of about 1000ppm-2 percent by weight. The moisture generator illustrated in Fig.6, does not allow the generation and supply of moisture to be controlled at such a low rate which may, for example, be 1-50cm³/min.

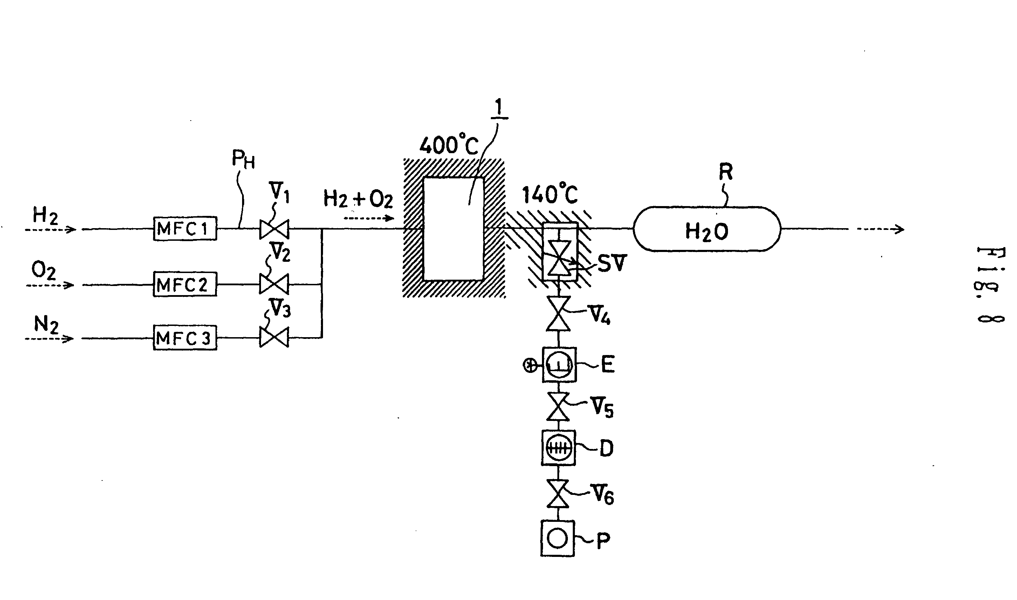

Fig. 8 shows testing apparatus which we have devised to test the response characteristics of the apparatus of Fig. 6 for the generation of moisture. Experiments were conducted using this testing apparatus, and the response characteristics of the apparatus were determined with the production of moisture kept at very low levels.

In Fig. 8, MFC1 to MFC3 indicate mass flow controllers; V1 to V6 are valves; SV is a suction-regulating valve; E is a quadruple mass spectrometer (Q-mass spectrometer); P is a vacuum pump (rotary pump); D is a turbo-molecular pump; and R is a moisture-collecting reservoir in which moisture is condensed at room temperature and collected. Said mass flow controllers MFC1 to MFC3 are so-called 'quick-start' type mass flow controllers, and are designed such that the hydrogen and oxygen flow rates O₂ will reach their pre-set flow rates very quickly.

For determination of the start-up response characteristics of the reactor 1 for generation of moisture, the flow rates of hydrogen, oxygen and nitrogen were first set to the levels in the four test cases shown below in Table 1 by means of the mass flow controllers MFC1 to MFC3. In each case, the concentration of the gases in the generated moisture and the generated amount of water were determined using the Q-mass spectrometer E. The valves V1 to V3 were actuated as follows: At start-up of the moisture generator, the valve V3 was closed and valve V2 was opened. Two seconds later, V1 was opened to produce moisture for one minute. When the moisture generation was to be ended, the valve V1 was closed, and two seconds after that, the valve V2 was closed, and the valve V3 was then opened to feed nitrogen to the reactor 1. Part of the gas flowing out of the reactor 1 was directed into the Q-mass spectrometer E, and a determination was made of the concentration of hydrogen, oxygen and nitrogen in the generated moisture and of the amount of water generated at measurement intervals of about one second.

**Table 1**

| | **Pre-Set Flow Rates/cm**^{**3**}**min**^{**-1**} | | |
|---|---|---|---|
| **Test** | **H**_{**2**} | **O**_{**2**} | **N**_{**2**}**.** |
| **1** | 5 | 1,075 | 5,000 |
| **2** | 10 | 1,075 | 5,000 |
| **3** | 20 | 1,075 | 5,000 |
| **4** | 50 | 1,075 | 5,000 |

The Q-mass spectrometer used was the model MSQ-150A Quadruple Mass Analyzer manufactured by ULVAC CORPORATION, Japan. The supply pressure was set to 2kgf/cm² for hydrogen, 2kgf/cm² for oxygen and 7kgf/cm² for nitrogen (all gauge pressures).

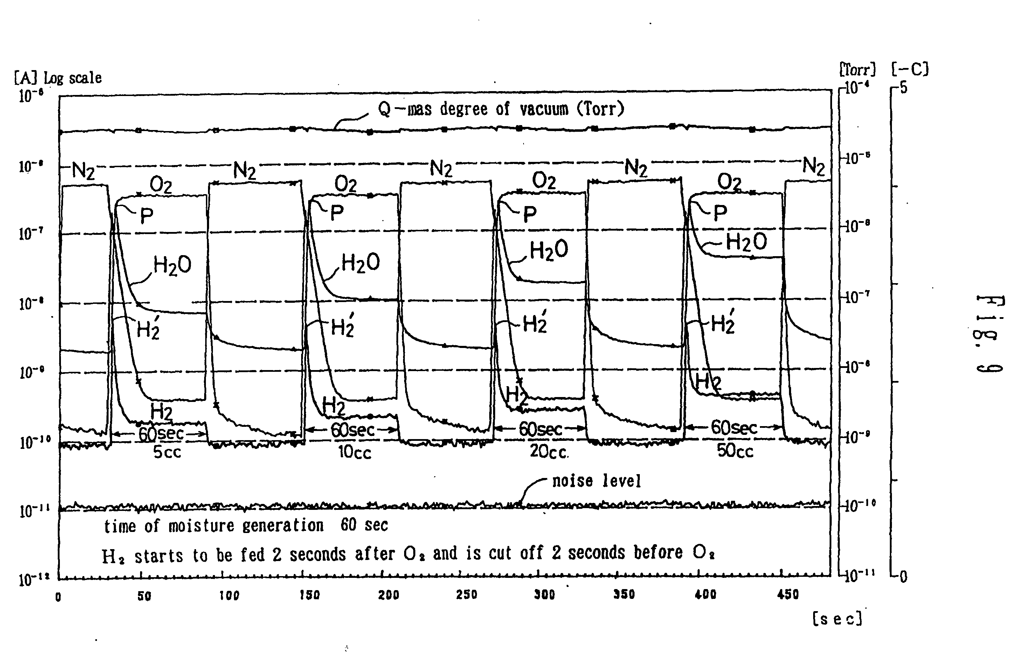

Fig.9 shows the results of the four tests. As illustrated in Fig. 9, the peak rate of moisture generation (P) was the same in each case. Thus for the moisture generator of Fig. 6, the amount of moisture generated when the moisture generation was small was almost the same in the initial stage irrespective of the flow rates of oxygen and hydrogen. In other words, it was shown that it is impossible to control the concentration of water vapour in the output gas, that is the flow rate of moisture using such apparatus.

A reason why all four cases peak at almost the same water vapour level in the moisture generation response curve may be that hydrogen remains trapped in the pipe line, the mass flow controller MFC1, the valve V1 and in other parts of the hydrogen gas supply system when a cycle is over. When the valve V1 is opened in the next cycle, this residual hydrogen flows into the reactor 1 where it is converted into water, thus creating a peak in the moisture generation response curve.

In Fig. 9, the concentration curve of hydrogen peaks at H2'. This may be because part of the water vapour led into the Q-mass spectrometer E decomposes into H₂+ions in the gas ionizer within the spectrometer E, and those ions manifest an apparently higher concentration of hydrogen.

An object of the present invention is to alleviate some or all of the problems encountered with the prior moisture generator.

It is thus an object of the present invention to provide a process for generating moisture which permits high precision control of the supply of moisture to a semiconductor manufacturing line, for example, at very low mass flow rates.

According to the invention there is provided a method of generating water vapour as claimed in claim 1.

The flow of the other gas may be controlled so that its mass flow rate increases to the respective preset level at a substantially constant rate of increase. The time taken before the pre-set flow rate is reached may be greater than 1 second, typically 1 - 10 seconds (e.g 2, 3, 4, 5, 6, 7, 8 or 9 seconds). Preferably the "start-up" period for the flow of said other gas is 5 - 6 seconds.

Alternatively, said other gas may be diverted for a period of more than 1 second after flow of said other gas is commenced; typically 1 - 10 seconds. In some embodiments, said other gas may be diverted for 5 - 6 seconds. Thereafter said other gas is supplied to the reactor.

Alternately, said water vapour may be discarded for a period of more than 1 second after the generation of water vapour commences; typically 1 - 10 seconds. In some embodiments, said water vapour may be discarded for 5 - 6 seconds. Therafter said water vapour may be supplied continuously to means utilising said water vapours such, for example, as semiconductor manufacturing plant.

Following is a description by way of example only with reference to the accompanying drawings of embodiments for carrying out the present invention.

In the drawings:-
Fig.1 is a system diagram of a moisture generator for carrying out the present invention.
Fig. 2 is a schematic diagram showing test apparatus for testing the response characteristics of the moisture generator of Fig. 1.
Fig. 3 shows moisture generation response curves which are the results of response characteristics tests carried out using the apparatus of Fig. 2.
Fig. 4 is a system diagram of a moisture generator according to another embodiment for carrying out the invention.
Fig. 5 is a system diagram of a moisture generator according to yet another embodiment for carrying out the invention.
Fig. 6 is a system diagram of a prior art apparatus for the generation of moisture.
Fig. 7 is a sectional view of a prior art reactor for the catalytic generation of moisture.
Fig. 8 is a schematic diagram showing test apparatus for testing the response characteristics of the apparatus of Fig. 6.
Fig. 9 shows moisture generation response curves which are the results of tests carried out using the test apparatus of Fig. 8.

### Example 1

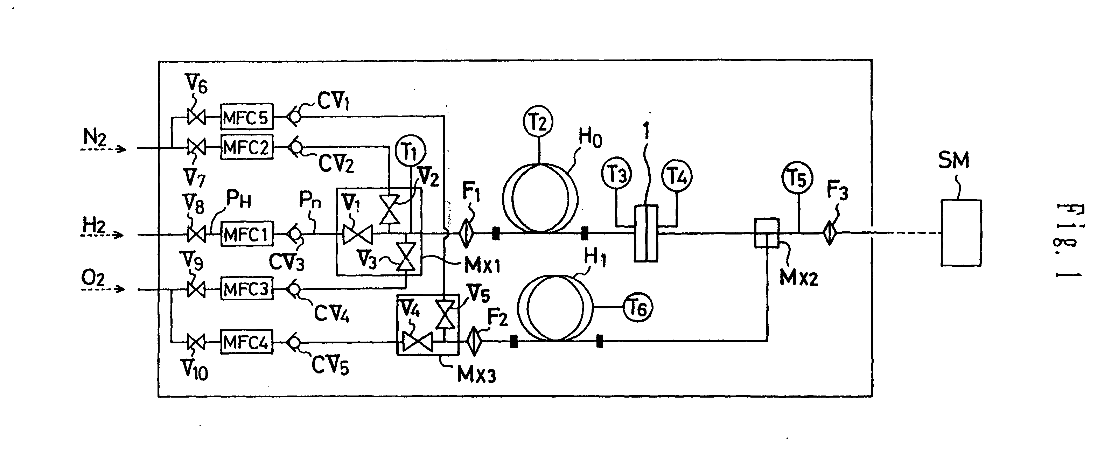

In Fig. 1 MFC1 to MFC5 are flow controllers such as mass flow controller; V1 to V10 are valves; T1 to T6 are thermocouples for measurement of temperature; CV1 to CV5 are check valves; F1 to F3 are filters; H1 and H2 are gas heater coils; Mx1 is an O₂-H₂O mixer; Mx2 is an O₂-H₂O mixer. 1 is a reactor for generation of moisture; and SM is a semiconductor manufacturing facility, such, for example, as an oxidation chamber to which generated moisture is supplied. Said moisture generator is similar to the one shown in Fig. 6, except that it is provided with valves V6 to V10 and uses a gradually-opening or slow-start mass flow controller MFC1 as mass flow controller.

That is, the mass flow controller MFC1 on the hydrogen gas supply line is so constituted that after hydrogen gas has started to be supplied to the primary or upstream side at a pressure of 1.0 to 3.0kgf/cm², the flow rate of hydrogen on the secondary or downstream side is gradually increased and reaches a specific pre-set level in some one to ten seconds. Preferably the mass flow controller MFC1 is a variable flow controller, such that the length of the "start-up" period at which the flow rate of gas is increased from 200 to pre-set level can be adjusted. Also, a valve V8 is provided on the inlet side of the mass flow controller MFC1 on the hydrogen supply line. By connecting this valve V8 directly with the mass flow controller MFC1, the dead space between the two is minimized.

To start up the reactor 1 for generation of moisture, the mass flow controllers MFC1 to MFC5 and temperature controllers are first set to predetermined values. The valves V2, V5, V6 and V7 are then opened, and the valves V1, V3, V4, V8, V9 and V10 are closed to purge the system with nitrogen.

Thereafter, the valves V2 and V5 are closed, and at the same time, or after a short time, the valves V3, V4, V9 and V10 are opened to feed oxygen into the system.

At the same time as oxygen starts to be fed, or a short time (typically one to three seconds) after that, the valves V1 and V8 are opened to feed the hydrogen into the system.

As the valves V1 and V8 are opened, hydrogen begins to flow into the reactor 1 for generation of moisture. As mentioned above, however, the mass flow controller MFC1 is of the 'slow-start' type, and the hydrogen flow rate through the valve V1 to mix with oxygen is not increased as suddenly as in the prior art system, but gradually increases according to the flow rate increase characteristics the mass flow controller MFC1. In the present embodiment, the rate of increase of the hydrogen flow rate through the mass flow controller MFC1 is such that the set flow rate - about 1-50cm³/min is reached in about 1-10 seconds, preferably 5-6 seconds. Any remaining hydrogen trapped in inside spaces of the mass flow controller MFC1, pipe line Pₙ and/or the valve V1 will therefore not be pushed into the reactor all at once.

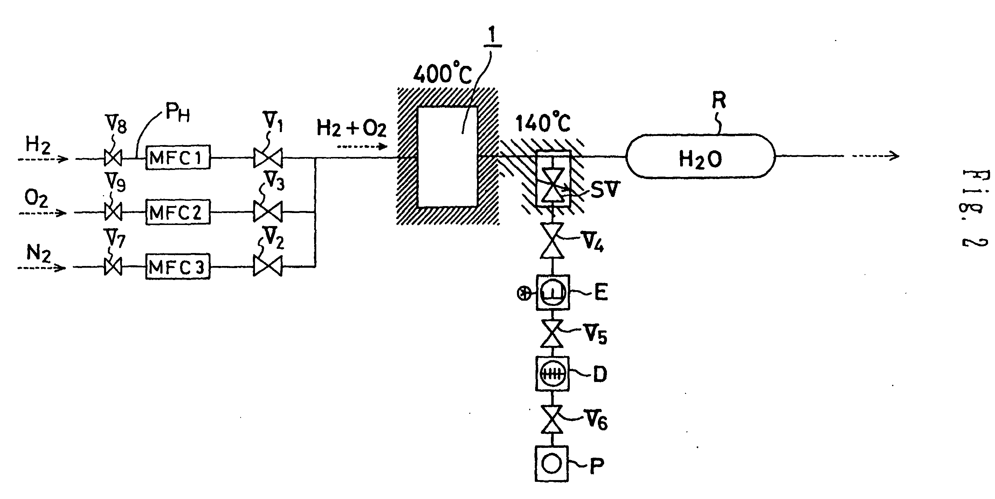

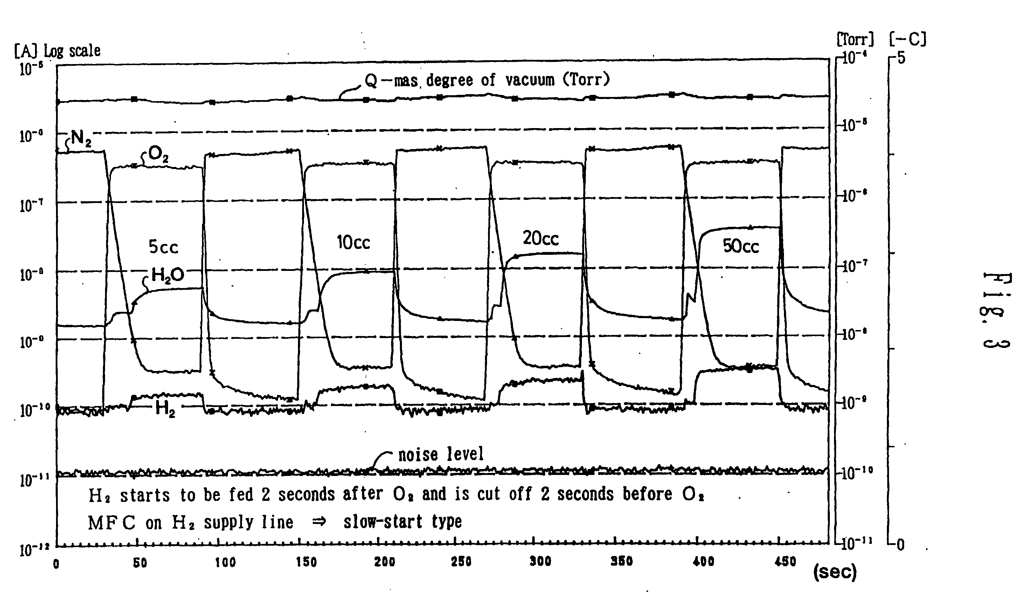

Fig. 3 shows the moisture generation response characteristics curves obtained with the reactor 1 for generation of moisture in the experimental arrangement shown in Fig. 2, in which a 'slow-start' type mass controller was used as mass flow controller MFC1. In this experiment, the valves were actuated as follows: At start-up, the valves V2 and V7 were closed while the valves V3 and V9 were opened. Two seconds later, the valves V1 and V8 were opened. Finally, the valves V1 and V8 were closed, and two seconds later the valves V3 and V9 were closed, and the valves V2 and V7 were opened.

The other conditions including the amount of hydrogen supplied were the same as those used in the testing the response characteristics shown in Fig. 9, and in addition the rate of increase of the flow rate provided by the mass flow controller MFC1 was set such that the flow rate of hydrogen would increase and reach the set levels of 5, 10, 20 and 50cm³/min (starting from 0cm³/min) in about 5 seconds.

It is confirmed that in operation the initial generation of water vapour is regulated at the respective set levels - 5,10,20 or 50 cm³/min - as is clear from Fig. 3. Thus, the moisture generation, that is, the mass flow rate of the moisture supply to a semiconductor manufacturing line for example, can be controlled precisely.

The method of Example 1 precludes any sudden rush into the reactor of hydrogen trapped in inside spaces of the flow controller and/or hydrogen pipe line which occurs when fresh hydrogen is supplied to the inlet side of the flow controller. Thus there is no concern that the generation of moisture will rise out of control if the generated amount is very small. Thus, the production of moisture at very low mass flow rates can be controlled with very high precision.

### Example 2

Example 1 above relates to 'oxygen-rich' generation of moisture in which a relatively large amount of oxygen and a relatively small amount of hydrogen are fed into the reactor 1, and a mixture of oxygen and water vapour flows out of the moisture outlet 5. According to Example 2, 'hydrogen-rich' generation of moisture (in which a relatively large amount of hydrogen and a relatively small amount of oxygen are fed into the reactor 1, and a mixture of hydrogen and moisture is taken out of the moisture outlet) is provided with high precision, as in the oxygen-rich operation, even when the moisture generation is small at 5-50cm³/min. This is accomplished by regulating the supply of oxygen using a slow-start, or gradually opening, flow controller such that the oxygen flow rate reaches a specific flow level starting from zero in a certain time - typically 1-10 seconds.

In Examples 1 and 2, the slow start-up mass flow controller may be any such, optionally adjustable, controller known and available to those skilled in the art. The flow controller may be of any type, including for example a pressure-type flow controller.

In another embodiment hydrogen and oxygen may be fed into the reactor 1 at ratio a stoichiometric of 2:1 such that the gas exhausted through the outlet consists exclusively and nearly exclusively of water vapour (steam).

### Example 3

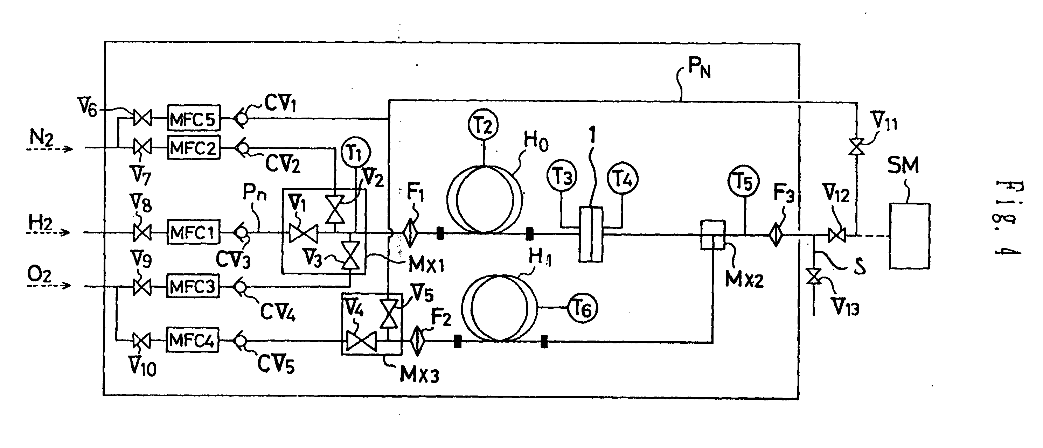

Fig. 4 shows the configuration of apparatus for the generation of moisture according to Example 3. A branch pipe S is provided on the moisture outlet side of the apparatus for generation of moisture, and an escape valve 13 is provided in the branch pipe S. Switch-over valves V11 and V12, and a purging pipe P_{N} are provided immediately at the upstream side of the semiconductor manufacturing line SM. The arrangements in Fig. 4 are otherwise the same as those shown in Fig. 1.

Referring to Fig. 4 nitrogen is initially fed to the semiconductor manufacturing line SM through the purging pipe Pn for purging the apparatus. Before moisture is supplied to the semiconductor manufacturing line SM, specific amounts of oxygen and hydrogen are fed into the reactor for generation of moisture. The escape valve V13 is set to an open position, such that the moisture generated initially is discharged from the apparatus to the surroundings. When the rate of moisture generation has stabilized, said escape valve V13 is closed, the switch-over valve V11 is closed, and the switch-over valve V12 is opened to feed subsequently generated moisture to the semiconductor manufacturing line SM at the pre-determined rate. The amount of moisture discharged through the escape valve is approximately equal to the volume of moisture produced at the peak point of moisture generation as shown in Fig. 9.

According to Example 3 the consumption of oxygen and hydrogen rise, because excessive moisture produced is discharged to the atmosphere before the supply of moisture to the semiconductor manufacturing line SM is started. However, the flow of moisture to the semiconductor manufacturing line SM can be controlled with very high precision.

According to the method of Example 3 the moisture generated initially in the reactor 1, which is generated at a rate exceeding the desired rate, is discharged to the outside through the escape valve. The supply of moisture to the line SM begins when the moisture generation has stabilized. Thus, the production of moisture, though very small, can be controlled with very high precision.

### Example 4

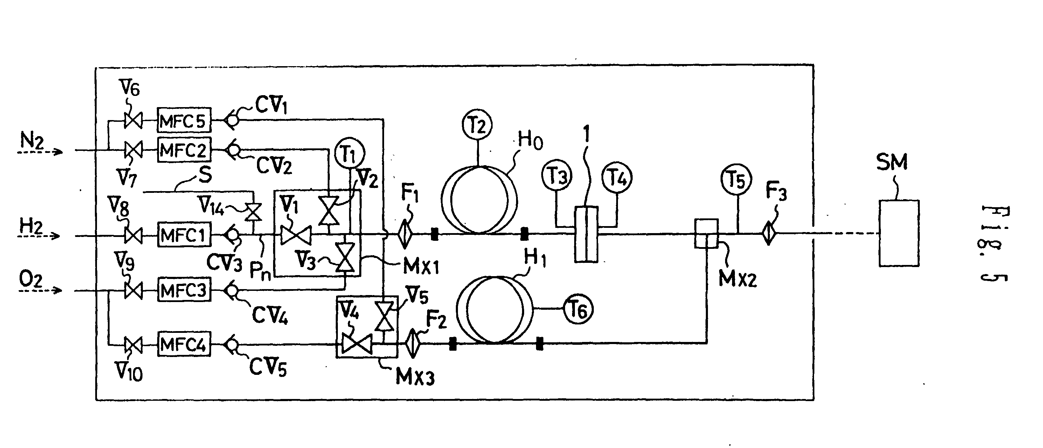

Fig. 5 shows the arrangement of apparatus for the generation of moisture according to Example 4 of the present invention, in which a branch pipe S is connected to the line on the outlet side of the mass flow controller MFC1 for feeding hydrogen, and an escape valve V14 is provided on said branch pipe S.

Before moisture generation is commenced, hydrogen trapped in the inside spaces of the valve V8, mass flow controller MFC1 and/or valve V1 is discharged through said escape valve V14. When the flow of hydrogen to the reactor has been regulated to the desired level the escape valve V14 is closed to direct the hydrogen into the reactor 1.

According to Example 4 the escape valve 14 is left open beforehand. Thus any excessive partial pressure of hydrogen trapped in the mass flow controller MFC1 and the pipe line is discharged almost completely. When hydrogen is subsequently is fed into the reactor 1 for the generation of moisture, there will be no sudden rush of hydrogen into the reactor 1, as in the prior art apparatus for generation of moisture as in Fig. 6.

When the flow of hydrogen has stabilized at a specific flow level preset by the mass flow controller MFC1, hydrogen is fed into the reactor 1 through the valve V1.

The flow of moisture from the reactor 1 can thus be controlled with very high precision, even where the flow is very low. The apparatus of Example 4 is configured such that a branch pipe to permit hydrogen to escape is provided on the outlet side of the flow controller which controls the flow of hydrogen. An escape valve is left open before hydrogen is fed into the inlet side of the reactor for generation of moisture, so that excessive hydrogen trapped inside is released through the escape valve. Thus any residual hydrogen is prevented from flowing suddenly into the reactor 1. According to this arrangement, there will be no unwanted peak of moisture concentration in the initial stage, and even if the moisture of a small amount is generated under oxygen-rich conditions, the supply to the semiconductor manufacturing line can be controlled with great precision.

### Examples 5 and 6

In Example 4, 'oxygen-rich' moisture generation is described. Of course the process of Example 4 can be modified to provide 'hydrogen-rich' moisture generation (Example 5) or the production of water vapour which is neither hydrogen rich nor oxygen rich by supplying hydrogen and oxygen to the reactor 1 in ratio of about 2 : 1 (Example 6).

In case of moisture generation under hydrogen rich conditions, a branch pipe S is provided on the downstream side of the oxygen flow controller MFC3. Excessive pressure of oxygen trapped between the flow controller MFC3 and the valve V3 is discharged in advance through the branch pipe S and the escape valve. Sudden flow of oxygen into the reactor 1 is thus prevented when the feeding of oxygen to the reactor is started. When the flow of oxygen has stabilized to a specific predetermined level, oxygen is introduced into the reactor 1.

It is confirmed that according to Example 5 the flow of moisture can be controlled with very high precision, even when the supply of moisture is very low, in hydrogen-rich moisture generation.

## Claims

1. A method of generating water vapour for use in a semiconductor manufacturing process, which method comprises supplying oxygen and hydrogen gases to a reactor (1), said reactor including a catalyst that is capable of producing hydrogen and oxygen radicals from said gases, which radicals react very quickly with one another to form water; and thereafter delivering water in gaseous form from the reactor (1); wherein each of said gases is supplied to the reactor (1) at a respective pre-set flow rate;
**characterised in that** on start-up
the supply of one of said hydrogen and oxygen gases is commenced at its respective pre-set flow rate, and thereafter the supply of the other gas is commenced and its flow rate being increased progressively in such manner that said flow rate of said other gas reaches its respective pre-set rate after any residual amount of said other gas has been delivered to the reactor;
or;
the supply of one of said gases is commenced at its respective pre-set flow rate, and thereafter the supply of the other gas is commenced, said other gas being diverted away from the reactor until any residual amount of said other gas has been purged;
or;
water vapour delivered from the reactor is discarded until water is delivered from the reactor at said predetermined rate;
thereby permitting high precision control of the supply of moisture to a semi conductor manufacturing line.

2. A method as claimed in claim 1, **characterised in that** the flow rate of the other gas is increased progressively to reach its pre-set flow rate 1 to 10 seconds after the supply of said other gas is commenced.

3. A method as claimed in claim 1 or claim 2,
**characterised in that** said one gas is oxygen and the other gas is hydrogen.

4. A method as claimed in claim 1 or claim 2,
**characterised in that** said one gas is hydrogen and the other gas is oxygen.

5. A method as claimed in claim 3, **characterised in that** the flow rates of said oxygen and hydrogen are such that the water vapour produced by the reactor is oxygen rich.

6. A method as claimed in claim 4, **characterised in that** the flow rates of said oxygen and hydrogen are such that the water vapour produced by the reactor is hydrogen rich.

7. A method as claimed in any of claims 1 to 4, **characterised in that** the flow rates of hydrogen and oxygen are pre-set such that the stoichiometric ratio of hydrogen to oxygen in the reactor is about 2:1.

## Patentansprüche

1. Verfahren zum Erzeugen von Wasserdampf zur Verwendung in einem Halbleiterfertigungsverfahren. wobei das Verfahren das Zuführen von Sauerstoffgas und Wasserstoffs in einen Reaktor (1), der eine Katalysatorschicht enthält, die aus den Gasen Wasserstoff- und. Sauerstofifradikale erzeugen kann, die sehr schnell miteinander zu Wasser reagieren, und danach das Fördern von Wasser in Gasform aus dem Reaktor (1) umfasst, wobei jedes der Gase mit einer vorgegebenen Strömungsrate dem Reaktor (1) zugeführt wird;
**dadurch gekennzeichnet, dass** bei Beginn:
die Zufuhr von Wasserstoffgas oder Sauerstoffgas mit der jeweils vorgegebenen Strömungsrate begonnen wird und danach die Zufuhr des anderen Gases begonnen wird und dessen Strömungsrate derart progressiv erhöht wird, dass die Strömungsrate des anderen Gases ihre jeweils vorgegebene Strömungsrate erreicht, nachdem eine Restmenge des anderen Gases zu dem Reaktor geleitet worden ist,
oder
die Zufuhr des einen Gases mit seiner jeweils vorgegebenen Strömungsrate begonnen wird und danach die Zufuhr des anderen Gases begonnen wird, wobei das andere Gas von dem Reaktor abgezweigt gehalten wird, bis eine Restmenge des anderen Gases gespült worden ist,
oder
Wasserdampf, der aus dem Reaktor gefördert wird, solange ausgeschieden wird, bis Wasser aus dem Reaktor mit der vorgegebenen Rate gefördert wird, wodurch eine hochpräzise Steuerung der Feuchtigkeitszufuhr zu einer Halbleiterfertigungsstraße möglich ist.

2. Verfahren nach Anspruch 1, **dadurch gekennzeichnet dass** die Strömungsrate des anderen Gases progressiv erhöht wird, um seine vorgegebene Strömungsrate 1 bis 10 Sekunden nach Beginn der Zufuhr des anderen Gases zu erreichen.

3. Verfahren nach Anspruch 1 oder 2, **dadurch gekennzeichnet dass** das eine Gas Sauerstoff und das andere Gas Wasserstoff ist.

4. Verfahren nach Anspruch 1 oder 2, **dadurch gekennzeichnet dass** das eine Gas Wasserstoff und das andere Gas Sauerstoff ist.

5. Verfahren nach Anspruch 3, **dadurch gekennzeichnet dass** die Strömungsraten des Sauerstoffs und Wasserstoffs derart sind, dass der durch den Reaktor erzeugte Wasserdampf sauerstoffreich ist

6. Verfahren nach Anspruch 4, **dadurch gekennzeichnet dass** die Strömungsraten des Sauerstoffs und Wasserstoffs derart sind, dass der durch den Reaktor erzeugte Wasserdampf wasserstoffreich ist.

7. Verfahren nach einem der Ansprüche 1 bis 4, **dadurch gekennzeichnet dass** die Strömungsraten des Wasserstoffs und Sauerstoffs derart vorgegeben sind, dass das stöchiometrische Verhältnis zwischen Wasserstoff und Sauerstoff in dem Reaktor etwa 2:1 ist.

## Revendications

1. Procédé pour produire de la vapeur d'eau à utiliser dans un processus de production de semi-conducteurs, ledit procédé comprenant les étapes consistant à fournir des gaz oxygène et hydrogène à un réacteur (1), ledit réacteur comprenant un catalyseur pouvant produire des radicaux d'hydrogène et d'oxygène à partir desdits gaz, lesquels radicaux réagissent très rapidement les uns avec les autres pour former de l'eau ; et ensuite à fournir de l'eau sous forme gazeuse à partir du réacteur (1) ; dans laquelle chacun desdits gaz est fourni au réacteur (1) à une vitesse d'écoulement prédéfinie respective ;
**caractérisé en ce que**, au démarrage :
l'alimentation en l'un desdits gaz hydrogène ou oxygène commence à sa vitesse d'écoulement prédéfinie respective, et ensuite l'alimentation en l'autre gaz commence et sa vitesse d'écoulement est progressivement augmentée de façon à ce que ladite vitesse d'écoulement dudit autre gaz atteigne sa vitesse prédéfinie respective après que toute quantité résiduelle dudit autre gaz a été fournie au réacteur ; ou
l'alimentation en l'un desdits gaz commence à sa vitesse d'écoulement prédéfinie respective, et ensuite l'alimentation en l'autre gaz commence, ledit autre gaz étant éloigné du reacteur jusqu'à ce que toute quantité résiduelle dudit autre gaz a été purgée ; ou
la vapeur d'eau fournie à partir du réacteur est mise au rebut jusqu'à ce que l'eau soit fournie à partir du réacteur à ladite vitesse prédéfinie ;
permettant ainsi un contrôle de grande précision de la fourniture d'humidité à une ligne de production de semi-conducteurs.

2. Procédé selon la revendication 1, **caractérisé en ce que** la vitesse d'écoulement de l'autre gaz est progressivement augmentée jusqu'à atteindre sa vitesse d'écoulement prédéfinie 1 à 10 secondes après le début de la fourniture de l'autre gaz.

3. Procédé selon la revendication 1 ou 2, **caractérisé en ce que** ledit premier gaz est de l'oxygène et l'autre gaz est de l'hydrogène.

4. Procédé selon la revendication 1 ou 2, **caractérisé en ce que** ledit premier gaz est de l'hydrogène et l'autre gaz est de l'oxygène.

5. Procédé selon la revendication 3, **caractérisé en ce que** les vitesses d'écoulement desdits oxygène et hydrogène sont telles que la vapeur d'eau produite par le réacteur est riche en oxygène.

6. Procédé selon la revendication 4, **caractérisé en ce que** les vitesses d'écoulement desdits oxygène et hydrogène sont telles que la vapeur d'eau produite par le réacteur est riche en hydrogène.

7. Procédé selon l'une quelconque des revendications 1 à 4, **caractérisé en ce que** les vitesses d'écoulement de l'hydrogène et de l'oxygène sont prédéfinies afin que le rapport stoechiométrique de l'hydrogène sur l'oxygène dans le réacteur soit d'environ 2:1.
